# EUROPÄISCHE PATENTANMELDUNG

(11) **EP 1 182 776 A2**
(43) Veröffentlichungstag der Anmeldung: **27.02.2002**
(21) Anmeldenummer: 01119400.8
(22) Anmeldetag: 11.08.2001
(51) Int. Cl.: H03F 3/217

(54) **Ansteuerschaltung für zumindest einen Leistungs-Halbleiterschalter**

(30) Priorität: 18.08.2000 EP 00117768
(71) Anmelder: Tyco Electronics AMP GmbH, 64625 Bensheim (DE)
(72) Erfinder: Bruck, Jürgen, 12524 Berlin (DE)
(74) Vertreter: Heinz-Schäfer, Marion

(57) **Zusammenfassung**

Die Erfindung schlägt eine Ansteuerschaltung für zumindest einen Leistungs-Halbleiterschalter vor, der seriell mit einer Last zwischen einem ersten und einem zweiten Versorgungspotentialanschluß verschalten ist. Die Ansteuerschaltung weist eine Gegentaktendstufe auf, die zwei in Reihe verschaltete Halbleiterschalter aufweist, die von einer Steuerschaltung gesteuert werden. Die Halbleiterschalter der Gegentaktendstufe sind dabei als eine erste und eine zweite Thyristorschaltung ausgeführt.

## Beschreibung

Die Erfindung betrifft eine Ansteuerschaltung für zumindest einen Leistungs-Halbleiterschalter, der seriell mit einer Last zwischen einem ersten und einem zweiten Versorgungspotentialanschluß verschalten ist, mit einer Gegentaktendstufe, die zwei in Reihe verschaltete Halbleiterschalter aufweist, die von einer Steuerschaltung gesteuert werden.

Ansteuerschaltungen mit einer Gegentaktendstufe sind aus dem Stand der Technik hinlänglich bekannt. Eine Gegentaktendstufe besteht aus zwei Halbleiterschaltern, die mit ihren Laststrecken seriell miteinander verschalten sind. Die Serienschaltung aus dem ersten und dem zweiten Halbleiterschalter ist zwischen einem hohen und einem niederen Versorgungspotentialanschluß verschalten. Mit dem Verbindungspunkt des ersten und des zweiten Halbleiterschalters ist eine Last, im hier vorliegenden Fall die Steuerelektrode eines Leistungs-Halbleiterschalters verbunden. Als Leistungs-Halbleiterschalter werden vorzugsweise Leistungs-MOSFET verwendet. Je nachdem, wie groß die Stromtragfähigkeit des Leistungs-Halbleiterschalters sein muß, können eine Vielzahl an Leistungs-MOSFETs den Leistungs-Halbleiterschalter bilden.

Um den Leistungs-Halbleiterschalter sowohl verlustarm als auch mit ausreichender Geschwindigkeit ansteuern zu können, ist ein entsprechend schneller Gate-Treiber mit einer entsprechend großen Stromverstärkung erforderlich. Die große Stromverstärkung wird benötigt, um die vergleichsweise große Gate-Kapazität des zu treibenden Leistungs-Halbleiterschalters in kurzer Zeit auf- und wieder entladen zu können. Die im Stand der Technik verwendeten Gegentaktendstufen weisen als erste und zweite Halbleiterschalter vielfach MOS-Transistoren auf. Diese MOSFETs haben im Sättigungsbereich nahezu lineare EIN-Widerstände (R_{DSon}), die bei großen Gate-Umladeströmen des Leistungs-Halbleiterschalters zu vergleichsweise großen Spannungsabfällen und damit zur teilweisen Entsättigung dieser MOSFETs führen. Zusätzlich ist damit ein Anstieg ihrer EIN-Widerstände verbunden. Hierdurch bedingt verlängern sich die Schaltzeiten der Leistungs-Halbleiterschalter. Es entstehen somit größere Verlustleistungen beim Abschalten. Eine Erwärmung der Leistungs-Halbleiterschalter ist die Folge, wodurch auch während der Leitphasen der EIN-Widerstand ansteigt und die Verluste während der Leitphase ansteigen.

Eine Gegentaktendstufe mit MOSFETs, die einen Leistungs-Halbleiterschalter treibt, der Ströme im Bereich von 1000 Ampere schalten muß, weist weitere Nachteile auf. Bei Lastströmen in dieser Größenordnung müssen der Steuerelektrode des Leistungs-Halbleiterschalters mehrere Ampere (10 Ampere...50 Ampere) bereitgestellt werden, wodurch die Gate-Kapazitäten sehr stark ansteigen. Soll die Steuerelektrode des Leistungs-Halbleiterschalters entladen werden, so ist eine möglichst niederohmige Entladung über den mit dem Bezugspotential verbundenen Halbleiterschalter der Gegentaktendstufe notwendig. Die Geschwindigkeit, mit der die Steuerelektrode entladen werden kann, ist im wesentlichen von der Stromtragfähigkeit bzw. der Aufnahmefähigkeit dieses Halbleiterschalters abhängig. Der Strom wird dabei im wesentlichen durch die Spannungssteilheit am Drain des mit dem Bezugspotential verbundenen MOSFETs der Gegentaktendstufe bestimmt. Bei einer hohen Spannungsanstiegsgeschwindigkeit kann von dem MOSFET ein hoher Gate-Entladestrom aufgenommen werden.

Es kann nunmehr der Fall auftreten, daß die Spannung am Drain dieses MOSFETs während des Abschaltens des Leistungs-Halbleiterschalters die Schwellenspannung des Leistungs-Halbleiterschalters übersteigt. In diesem Fall ist eine sichere Sperrung des Leistungs-Halbleiterschalters nicht mehr gewährleistet. Diese Problematik tritt insbesondere bei einer Konfiguration auf, in der die Last mit dem hohen Versorgungspotentialanschluß verbunden ist. Eine derartige Konfiguration wird als Low-Side-Konfiguration bezeichnet.

Es besteht nunmehr das dringende Bedürfnis, eine Ansteuerschaltung für einen Leistungs-Halbleiterschalter vorzusehen, die in der Lage ist, diesen schnell und verlustarm und sicher zu betreiben.

Die Aufgabe der vorliegenden Erfindung besteht deshalb darin, eine eingangs beschriebene Ansteuerschaltung für einen Leistungs-Halbleiterschalter bereitzustellen, die eine Gegentaktendstufe aufweist und die dazu geeignet ist, sehr hohe Lastströme zu schalten.

Diese Aufgabe wird mit den Merkmalen des Patentanspruchs 1 gelöst.

Der Erfindung liegt der Gedanke zugrunde, den Innenwiderstand der Halbleiterschalter der Gegentaktendstufe so auszubilden, daß diese in kurzer Zeit den von der Steuerelektrode des Leistungs-Halbleiterschalters abfließenden Strom aufnehmen können, ohne daß der Spannungsabfall der Halbleiterschalter der Gegentaktendstufe ansteigt und dabei die Schwellenspannung des Leistungs-Halbleiterschalters übersteigt.

Erfindungsgemäß ist deshalb vorgesehen, die Halbleiterschalter der Gegentaktendstufe als eine erste und eine zweite Thyristorschaltung auszuführen. Hiermit ist es möglich, große Gateladungen bei einem Leistungs-Halbleiterschalter, der aus einer Vielzahl von parallel geschalteten MOSFETs bestehen kann, in kurzer Zeit zu übertragen. Die Verwendung einer ersten und einer zweiten Thyristorschaltung in einer Gegentaktanordnung weist einen logarhithmischen Anstieg des Spannungsabfalls mit steigendem Strom auf. Hierdurch gibt es - auch bei großen Strömen - grundsätzlich keine Entsättigung der Halbleiterschalter der Gegentaktendstufe. Die erfindungsgemäßen Thyristorschaltungen sind zudem in der Lage, sehr viel größere Ströme mit sehr hohen Anstiegsgeschwindigkeiten zu führen als konventionelle MOSFETs einer Gegentaktendstufe. Die erfindungsgemäße Ansteuerschaltung weist deshalb gegenüber einer aus dem Stand der Technik bekannten Ansteuerschaltung wesentlich weniger Verluste auf. Ein weiterer Vorteil der erfindungsgemäßen Ansteuerschaltung besteht darin, daß der Spannungsabfall der mit dem Bezugspotentialanschluß verbundenen Thyristorschaltung sicher unterhalb der Schwellenspannung des Leistungs-Halbleiterschalters gehalten werden kann. Somit ist ein sicheres Sperren des Leistungs-Halbleiterschalters in der Ausschaltphase gewährleistet. Ein plötzliches Ansteigen der Spannung am Ausgang der Gegentaktendstufe, die mit der Steuerelektrode des Leistungs-Halbleiterschalters verbunden ist, kann auch bei sehr hohen Gate-Entladeströmen nicht auftreten.

In einer vorteilhaften Ausgestaltung der Erfindung weisen die erste und die zweite Thyristorschaltung jeweils zwei komplementäre Halbleiterschalter, insbesondere Bipolartransistoren auf, deren Basis- und Kollektoranschlüsse miteinander verschalten sind. Durch die Verschaltung eines ersten und eines zweiten bipolaren Bauelementes zu einer Thyristorschaltung werden die oben beschriebenen Vorteile erzielt. Dieses Vorgehen ermöglicht insbesondere, daß die Thyristorschaltung mehrfach steuerbar ist. Die Funktionalität der gesamten Ansteuerschaltung kann auf diese Weise sehr einfach realisiert werden.

In einer Weiterbildung der Thyristorschaltung ist eine Diode zwischen den Basis- und Kollektoranschlüssen des ersten und des zweiten Halbleiterschalters geschaltet. Bei hohen Strömen wird hierdurch eine kontrollierte Verteilung der Basis-Kollektor-Ströme der beiden Bipolartransistoren erreicht. Der Hauptstrom der Thyristorschaltung fließt somit über die Kollektoren der Bipolartransistoren und über die Diode. Die jeweiligen Basis-(Sättigungs-)Spannungen und Kollektor-(Sättigungs-)Spannungen stellen sich dabei derart ein, daß eine Übersteuerung, die mit sehr hohen Raumladungen verbunden ist, vermieden wird und somit eine unverzögerte Steuerbarkeit erhalten bleibt. Eine derartige Thyristor-schaltung weist deshalb keinen Trägheitseffekt auf und ist in der Lage, mit hohen Geschwindigkeiten zu agieren. Zudem wird die Ansammlung von Ladungsträgern in der Sperrschicht der Bipolartransistoren vermieden, wodurch sich ebenfalls eine sehr hohe Schaltgeschwindigkeit ergibt.

Vorteilhafterweise wird als Diode eine Schottky-Diode verwendet. Da bei den angestrebten Lastströmen im Bereich von mehr als 1000 Ampere geeignete Silizium-Bipolartransistoren bereits Basis-Sättigungsspannungen von ca. 1,2 Volt und Kollektor-Sättigungsspannungen von ca. 0,5 Volt aufweisen können, wird vorteilhafterweise eine Silizium-Schottky-Diode verwendet. Diese wird derart dimensioniert, daß die bei den erwähnten Lastströmen resultierenden Gate-Lade-/Entladeströmen, einen Spannungsabfall entsprechend der Differenz der Sättigungsspannung aufweist. Vorteilhafterweise weist die Schottky-Diode darüber hinaus einen kleinen Reststrom bei hohen Temperaturen auf. Hierdurch können "Überkopf-Zündungen" vermieden werden. Der Spannungsabfall bei einer derart dimensionierten Schottky-Diode liegt dann unter einem Volt.

Eine erfindungsgemäß ausgebildete Thyristorschaltung läßt sich sowohl an den Steuereingängen, d.h. an den Basisanschlüssen der beiden Bipolartransistoren als auch im Hauptpfad unverzögert steuern.

In einer Ausgestaltung der Erfindung sind der erste Halbleiterschalter der ersten Thyristorschaltung und der erste Halbleiterschalter der zweiten Thyristorschaltung jeweils mit ihren Basis- und Emitter-Anschlüssen verbunden. Der Verbindungspunkt der Emitter-Anschlüsse ist mit dem Steueranschluß des zumindest einen Leistungs-Halbleiterschalters gekoppelt. Die zwei besagten Halbleiterschalter der ersten und der zweiten Thyristorschaltung sind dabei vom komplementären Typ. Durch diesen extrem einfachen Aufbau können der erste und der zweite Thyristor niemals gleichzeitig leiten.

Vorteilhafterweise wird eine dritte Thyristorschaltung mit den Basisanschlüssen der Halbleiterschalter der ersten Thyristorschaltung verbunden. Unter der ersten Thyristor-schaltung wird im folgenden diejenige Thyristorschaltung der Gegentaktstufe verstanden, die mit einem hohen Versorgungspotential verbunden ist. Dementsprechend ist die zweite Thyristorschaltung mit einem niederen Bezugspotential verschalten. Durch die Verbindung einer dritten Thyristorschaltung mit der ersten Thyristorschaltung kann der erste Thyristor mittels sehr großen Strömen gezündet werden. Auf diese Weise ist eine Verringerung der Signallaufzeiten möglich.

Vorteilhafterweise wird die dritte Thyristorschaltung ihrerseits durch eine pulsartige Stromquelle gezündet. Diese ist dann mit einer Steuersignaleinrichtung verbunden. Hierdurch kann mit einem Steuersignal von wenigen µA über die Steuersignaleinrichtung und die dritte Thyristorschaltung ein Strom von mehreren Ampere erzeugt werden, der zum Laden des Steueranschlusses des Leistungs-Halbleiterschalters herangezogen wird. Die pulsartige Stromquelle ist vorteilhafterweise als Bipolartransistor ausgebildet. Der Basisstrom für diese pulsartige Stromquelle, d.h. für den Bipolartransistor, wird idealerweise nur während der Schaltflanke der Steuersignaleinrichtung erzeugt.

In einer vorteilhaften Weiterbildung der Erfindung ist die erste Thyristorschaltung mit einem Ladungsspeicher verbunden. Wird der Ladungsspeicher geeignet groß dimensioniert, kann der Steueranschluß des Leistungs-Halbleiterschalters sehr schnell aufgeladen werden, sobald die erste Thyristorschaltung leitend geworden ist.

In einer weiteren vorteilhaften Ausgestaltung der Erfindung ist die zweite Thyristorschaltung über eine Diode mit der Steuersignaleinrichtung verbunden. In diesem Fall ist das Leitendsteuern der zweiten Thyristoreinrichtung zu den Zeiten, in denen der erste Thyristorschaltung sperrt, auf äußerst einfache Weise möglich. Hierzu wird der Basisanschluß eines Bipolartransistors der zweiten Thyristorschaltung über die Diode mit der Steuersignaleinrichtung verbunden.

In einer weiteren Ausgestaltung der Erfindung sind die Basis-und Emitter-Anschlüsse der zweiten Halbleiterschalter der ersten und der zweiten Thyristorschaltung jeweils über einen Widerstand mit dem ersten bzw. zweiten Versorgungspotentialanschluß verbunden. Hierdurch ist ein selbständiges Erlöschen des ersten Thyristors gewährleistet, da hierdurch bestimmt werden kann, wann die logarhithmische Kennlinie des Spannungsabfalls mit steigendem Strom abgearbeitet ist. Andererseits kann bei einer vorhanden Überlast bzw. Gate-Unterspannungserkennung die zweite Thyristorschaltung gezündet werden, wodurch ein sehr guter Schutz der gesamten Ansteuerschaltung erzielt wird.

Vorteilhafterweise ist eine Serienschaltung aus einem Widerstand und einer Diode zwischen dem ersten Versorgungspotentialanschluß und dem Verbindungspunkt zwischen der ersten und der zweiten Thyristorschaltung vorgesehen. In einem Fehlerfall, der beispielsweise eine Überlast, eine Unterspannung an dem Steueranschluß des Leistungs-Halbleiterschalters oder eine zu hohe Spannung an den Hauptelektroden des Leistungs-Halbleiterschalters darstellen kann, kann der zweiten Thyristorschaltung ein Haltestrom zugeführt werden, wodurch der Leistungs-Halbleiterschalter sicher in einem gesperrten Zustand gehalten wird. Wird die Diode vorteilhafterweise als Leuchtdiode ausgeführt, so kann ein auftretender Fehlerfall von außen erkannt werden.

Die Ansteuerschaltung kann sowohl in einer Low-Side-Konfiguration als auch in einer High-Side-Konfiguration verschalten sein. Bei einer Low-Side-Konfiguration ist die Last zwischen dem ersten Versorgungspotentialanschluß und einem Hauptanschluß des Leistungs-Halbleiterschalters verschalten. Der andere Hauptanschluß des Leistungs-Halbleiterschalters ist folglich mit dem zweiten Versorgungspotentialanschluß, der ein Bezugspotential, z.B. Masse darstellt, verschalten.

Im Gegensatz dazu ist bei einer High-Side-Konfiguration die Last zwischen dem zweiten Versorgungspotentialanschluß und einem Hauptanschluß des Leistungs-Halbleiterschalters verschalten. Der andere Hauptanschluß ist mit dem ersten Versorgungspotentialanschluß verbunden.

Bei einer Low-Side-Konfiguration ist in einer vorteilhaften Ausgestaltung der Erfindung eine Überlast- bzw. Unterspannungserkennung in Form einer Serienschaltung zweier Widerstände vorgesehen, wobei die Serienschaltung zwischen dem Verbindungspunkt zwischen der ersten und der zweiten Thyristorschaltung und dem Basisanschluß des zweiten Halbleiterschalters der zweiten Thyristorschaltung gelegen ist. Im Falle einer Überspannung (Überlast) führt der Spannunganstieg an einem der Widerstände zu einem Übersteigen der Basis-Emitter-Spannung eines der Halbleiterschalter der zweiten Thyristorschaltung, wodurch diese gezündet wird und den Leistungs-Halbleiterschalter sperrt.

Vorteilhafterweise wird an den Verbindungspunkt der beiden Widerstände ein Ladungsspeicher geschalten. In diesem Fall ist eine Einstellung möglich, wie schnell eine Überlasterkennung ansprechen soll. Somit ist mit Hilfe nur weniger Bauelemente ein guter Schütz der Leistungs-Halbleiterschalter gewährleistet.

Die nunmehr folgenden weiteren vorteilhaften Ausgestaltungen beziehen sich ausschließlich auf die High-Side-Konfiguration. Vorteilhafterweise wird in einer Ausgestaltung der Erfindung eine Überlasterkennung vorgesehen, die Mittel zur Wandlung der Drain-Source-Spannung des Leistungs-Halbleiterschalters in einen Strom enthält, wobei dieser Strom dem Basisanschluß des zweiten Halbleiterschalters der zweiten Thyristorschaltung zugeführt wird. Die Mittel weisen hierzu zumindest einen Widerstand und einen mit der Laststrecke dazu seriell verschalteten Halbleiterschalter auf, der vorteilhafterweise als Bipolartransistor ausgeführt ist. Ist zusätzlich ein Ladungsspeicher vorgesehen, so kann in einem Überlastfall eine Abschaltung über den Widerstand und den Ladungsspeicher erfolgen, wobei die Verzögerung des Abschaltens durch die beiden genannten Bauelemente eingestellt wird. Ein kleiner Widerstand führt zu einer schnellen Abschaltung des Leistungs-Halbleiterschalters.

Vorteilhafterweise wird die Überlasterkennung über einen mit dem Leistungs-Halbleiterschalter gekoppelten MOSFET aktiviert. Der MOSFET ist vorteilhafterweise mit dem Mittel zur Wandlung der Drain-Source-Spannung des Leistungs-Halbleiterschalters in Serie verschalten, wobei die Spannung erst dann in einen Strom gewandelt werden kann, wenn der Leistungs-Halbleiterschalter niederohmig ist. Auf diese Weise wird sichergestellt, daß die zweite Thyristorschaltung durch die Überlasterkennung nicht permanent leitend geschalten wird, wodurch die Ansteuerschaltung den Leistungs-Halbleiterschalter niemals einschalten könnte.

Vorteilhafterweise wird bei einer induktiven oder bei einer resistiv-induktiven Last ein mit der pulsförmigen Stromquelle verbundener Einschaltschutz vorgesehen. Hierdurch wird sichergestellt, daß während des Abkommutierens der induktiven Last der Leistungs-Halbleiterschalter trotz eines anstehenden Einschaltimpulses durch die Steuersignaleinrichtung nicht leitend geschalten werden kann. Dies bedeutet, daß eine Zündung der ersten Thyristorschaltung in jedem Fall unterbunden wird.
Besonders vorteilhaft ist es, wenn ein Ladungsspeicher über die erste Thyristorschaltung zwischen der Steuerelektrode und dem Verbindungspunkt zwischen dem Leistungs-Halbleiterschalter und der Last geschalten ist. Bei einer Schwankung der Versorgungsspannung ist somit bei gezündeter erster Thyristorschaltung sicher gestellt, daß die Spannung am Steueranschluß des Leistungs-Halbleiterschalters niemals unter die Schwellenspannung sinken kann. Dies wird insbesondere dadurch ermöglicht, daß der Ladungsspeicher nach dem Bootstrap-Prinzip arbeitet.

Weitere Vorteile und Ausgestaltungen der Erfindung ergeben sich aus den nachfolgenden Figuren. Es zeigen:
- Figur 1: eine erfindungsgemäße Ansteuerschaltung für eine Low-Side-Konfiguration und
- Figur 2: eine erfindungsgemäße Ansteuerschaltung für eine High-Side-Konfiguration.

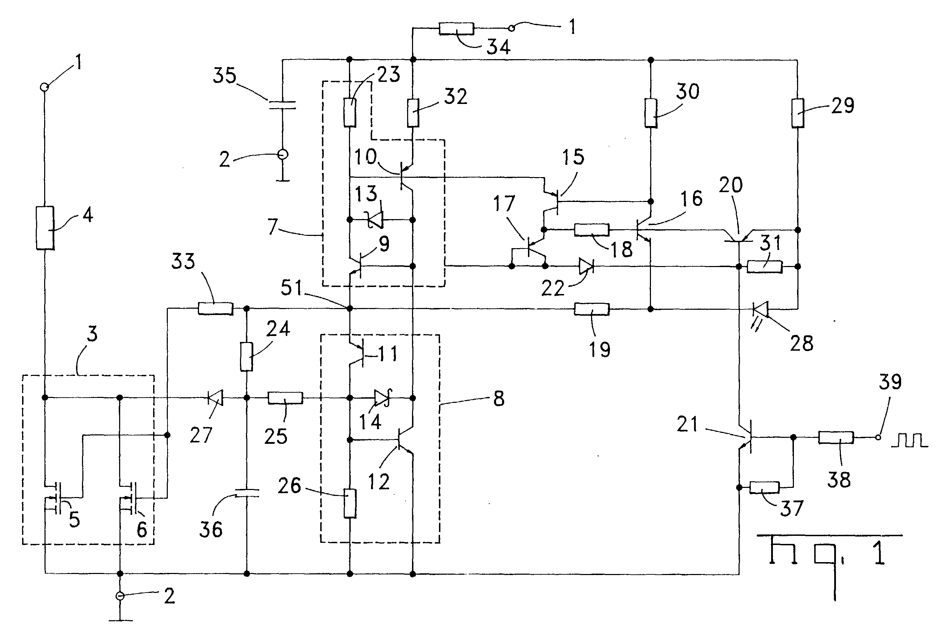

Die Figur 1 zeigt ein erstes Ausführungsbeispiel der erfindungsgemäßen Ansteuerschaltung in einer Low-Side-Konfiguration. Zwischen einem ersten Versorgungspotentialanschluß 1 und einem zweiten Versorgungspotentialanschluß 2 ist die Reihenschaltung aus einer Last 4 und einem Leistungs-Halbleiterschalter 3 verschalten. Die Last 4 ist mit ihrem ersten Anschluß mit dem ersten Versorgungspotentialanschluß 1 verbunden, während sie mit ihrem zweiten Anschluß mit dem Leistungs-Halbleiterschalter 3 verbunden ist. Der Leistungs-Halbleiterschalter 3 kann aus einer Vielzahl an parallel geschalteten MOSFETs 5,6 bestehen. Die MOSFETs sind dann mit ihren Drainanschlüssen, mit ihren Sourceanschlüssen und mit ihren Gateanschlüssen miteinander verbunden. Sourceseitig sind die MOSFETs 5,6 mit dem zweiten Versorgungspotentialanschluß 2 verbunden, der üblicherweise ein Bezugspotentialanschluß (z.B. Masse) darstellt. Drainseitig sind die MOSFETs 5,6 mit der Last 4 verbunden.

Die Ansteuerschaltung weist eine erste Thyristorschaltung 7 und eine zweite Thyristorschaltung 8 auf, die in Gegentaktanordnung angeordnet sind. Die erste Thyristorschaltung 7 weist einen NPN-Bipolartransistor 9 und einen PNP-Bipolartransitor 10 auf. Der Basisanschluß des Bipolartransistors 9 ist mit dem Kollektoranschluß des Bipolartransistors 10 verschalten, während der Kollektoranschluß des Bipolartransistors 9 mit der Basis des Bipolartransistors 10 in Verbindung steht. Zwischen den Kollektoranschlüssen der Bipolartransistoren 9,10 ist eine Schottky-Diode 13 gelegen, wobei ihr Anodenanschluß mit dem Kollektor des Bipolartransistors 10 verbunden ist. Die erste Thyristorschaltung 7 weist weiterhin einen Widerstand 23 auf, der mit dem ersten Anschluß mit der Basis des Bipolartransistors 10 und mit dem zweiten Anschluß über einen weiteren Widerstand 34 mit dem ersten Versorgungspotentialanschluß 1 verbunden ist.

Die zweite Thyristorschaltung 8 besteht ebenfalls aus zwei Bipolartransistoren 11,12 wobei der erste Bipolartransistor 11 vom PNP-Typ ist. Der zweite Bipolartransistor 12 ist hingegen vom NPN-Typ. Der Basisanschluß des Bipolartransistors 11 ist mit dem Kollektor des Bipolartransistors 12 verbunden, während die Basis des Bipolartransistors 12 mit dem Kollektoranschluß des Bipolartransistors 11 in Verbindung steht. Zwischen den Kollektoren der Bipolartransistoren 11,12 ist gleichfalls eine Schottky-Diode 14 vorgesehen, die anodenseitig mit dem Kollektoranschluß des Bipolartransistors 11 verbunden ist. Die Basis des Bipolartransistors 12 ist über einen Widerstand 26 mit dem zweiten Bezugspotentialanschluß 2 verbunden. Der Emitter des Bipolartransistors 12 steht ebenfalls mit dem zweiten Versorgungspotentialanschluß 2 in Verbindung.

Der Ausgang der Ansteuerschaltung wird durch den Verbindungspunkt 51 gebildet, der mit dem Emitter-Anschluß des ersten Bipolartransistors 9 der ersten Thyristorschaltung und dem Emitteranschluß des Bipolartransistors 11 der zweiten Thyristorschaltung gebildet wird. Gleichfalls sind die Basisanschlüsse der Bipolartransistoren 9,11 miteinander verbunden. Die Bipolartransistoren 9,11 sind dabei vom komplementären Typ. Hierdurch ist sicher gestellt, daß kein Querstrom durch die erste und die zweite Thyristorschaltung fließen kann. Dies bedeutet mit anderen Worten, daß entweder die erste Thyristorschaltung 7 oder die zweite Thyristorschaltung 8 leitend sein kann.

Der Ausgang der Ansteuerschaltung (Verbindungspunkt 51) ist über einen Widerstand 33 mit dem Steueranschluß des Leistungs-Halbleiterschalters 3 verbunden. Der Widerstand 33 dient zur Flankenverrundung, wodurch die elektromagnetische Abstrahlung gering gehalten werden kann.

Die erste Thyristorschaltung 7 wird mit einer dritten Thyristorschaltung, die durch die Bipolartransistoren 15,16 gebildet ist, gezündet. Hierzu ist der Basisanschluß des Bipolartransistors 10 mit dem Emitter des PNP-Transistors 15 verbunden. Der Basisanschluß des Bipolartransistors 15 ist mit dem Kollektor des NPN-Bipolartransistors 16 verbunden. Die Basis des Bipolartransistors 16 ist über einen Widerstand 18 mit dem Kollektor des Bipolartransistors 15 verbunden. Der Kollektor des Bipolartransistors 15 ist ferner mit einer Diode verbunden, die als PNP-Bipolartransistor 17 ausgeführt ist. Der Emitter des Bipolartransistors 17 ist dabei mit dem Kollektor des Bipolartransistors 15 verbunden. Der Basis- und Kollektoranschluß des Bipolartransistors 17 sind miteinander verschalten und stehen mit der Basis des Bipolartransistors 9 der ersten Thyristorschaltung 7 in Verbindung. Der Emitteranschluß des Bipolartransistors 16 ist über einen Widerstand 19 mit dem Verbindungspunkt 51, d.h. mit dem Ausgang der Ansteuerschaltung verbunden. Mittels der Diode 17 und den beiden Widerständen 18,19 kann der dritte Thyristor, bestehend aus den Bipolartransistoren 15,16, außerhalb der Sättigung gehalten werden. Zudem ist gewährleistet, daß nach der Schaltflanke einer pulsartigen Stromquelle 20 der dritte Thyristor 15,16 selbsttätig löscht.

Die Zündung der dritten Thyristorschaltung wird über eine pulsartige Stromquelle 20 ermöglicht, wobei diese als PNP-Bipolartransistor ausgeführt ist. Der Kollektor des Bipolartransistors 20 steht dabei mit der Basis des Bipolartransistors 16 der dritten Thyristorschaltung in Verbindung. Der Emitter ist über einen Widerstand 31 mit der Basis verbunden. Der Bipolartransistor 20 erhält seinen Basisstrom aus den Umladungen der Kollektor-Basis-Kapazität des Bipolartransistors 21. Zusätzlich erhält der Bipolartransistor 20 seinen Basisstrom aus der Sperrschichtkapazität einer Diode 22, die anodenseitig mit dem Kollektor des Bipolartransistor 17 und kathodenseitig mit dem Basisanschluß des Bipolartransistor 20 verbunden ist. Der Bipolartransistor 21 ist mit seinem Kollektor mit der Basis des Bipolartransistors 20 verschalten, während er emitterseitig mit dem zweiten Versorgungspotentialanschluß 2 in Verbindung steht. Der Basisanschluß ist einerseits über einen Widerstand 37 mit dem Emitter verbunden und andererseits über einen Widerstand 38 mit einem Steuersignaleingang 39.

Ein Widerstand 30, der zwischen dem Basisanschluß des Bipolartransistors 15 der dritten Thyristorschaltung und dem Verbindungspunkt aus dem Widerstand 34 und dem Widerstand 23 gelegen ist, dient zur Entkopplung. Mit dem Verbindungspunkt zwischen den Widerständen 34,23 ist ferner ein Anschluß eines Ladungsspeichers 35 verbunden. Dieser steht mit seinem anderen Anschluß mit dem zweiten Versorgungspotentialanschluß 2 in Verbindung. Der Ladungsspeicher 35 ist als Kondensator ausgeführt. Dieser stellt nach dem Zünden der ersten Thyristorschaltung 7 dem Gate der MOSFETs 5,6 ausreichend Ladung zur Verfügung und dient somit der Beschleunigung des Schaltvorganges. Zwischen dem Widerstand 19 und dem Verbindungspunkt aus den Widerständen 23,34 ist ferner eine Serienschaltung aus einer Diode 28 und einem Widerstand 29 geschalten. Die Diode 28 ist katodenseitig einerseits mit dem Widerstand 19 und andererseits mit dem Emitter des Bipolartransistors 16 der dritten Thyristorschaltung verbunden. Die Anode steht einerseits mit dem Emitter des Bipolartransistors 20 (pulsartige Stromquelle) und einem Anschluß des Widerstands 29 in Verbindung. Der andere Anschluß des Widerstands 29 ist mit dem Verbindungspunkt der Widerstände 23,34 verbunden.

Zwischen dem Verbindungspunkt 51 und dem zweiten Versorgungspotentialanschluß 2 ist die Serienschaltung aus einem Widerstand 24 und einem Ladungsspeicher 36, der als Kondensator ausgeführt ist, verbunden. Der Kondensator 36 steht dabei mit dem zweiten Versorgungspotentialanschluß 2 in Verbindung, während ein Anschluß des Widerstands 24 mit dem Verbindungspunkt 51 verbunden ist. An den Verbindungspunkt zwischen dem Widerstand 24 und dem Kondensator 36 ist ein Widerstand 25 geschalten, der mit seinem anderen Anschluß mit der Basis des Bipolartransistors 12 der zweiten Thyristorschaltung 8 verbunden ist. Mit dem Verbindungspunkt zwischen dem Widerstand 24 und dem Ladungsspeicher 36 ist gleichfalls der Anodenanschluß einer Diode 27 geschalten, wobei der Kathodenanschluß mit dem Verbindungspunkt zwischen dem Leistungs-Halbleiterschalter 3 und der Last 4 vorgenommen ist. Die Widerstände 24,25 sowie der Ladungsspeicher 36 dienen einer Überlasterkennung des Leistungs-Halbleiterschalters 3. Durch die Dimensionierung des Ladungsspeichers 36 kann festgelegt werden, ob die Überlasterkennung langsam oder schnell erfolgen soll. Je schneller eine Erkennung stattfinden soll, desto kleiner muß der Ladungsspeicher 36 ausgelegt werden.

Durch die genannten Elemente wird gleichermaßen bewirkt, daß bei einem Abschalten des Leistungs-Halbleiterschalters 3 beim Ansteigen der Gate-Spannung durch die Miller-Kapazität am Leistungs-Halbleiterschalter 3 dessen erneutes Einschalten verhindert wird. In diesem Fall findet ein Spannungsanstieg am Emitter des Bipolartransistors 11 statt, wodurch das sofortige Zünden der zweiten Thyristorschaltung 8 eingeleitet wird.

Im folgenden wird die Funktionsweise der erfindungsgemäßen Ansteuerschaltung für eine Low-Side-Konfiguration näher erläutert. Zum Einschalten des Leistungs-Halbleiterschalters 3 ist ein Zünden der ersten Thyristorschaltung 7 notwendig. Dies geschieht durch Anliegen eines Steuersignals am Steuersignaleingang 39, wobei durch den Bipolartransistor 21 ein Strom fließt, während am Steuersignaleingang 39 eine abfallende Signalflanke anliegt. Durch diesen Steuerstrom, d.h. dem Umladen der Kollektor-Basis-Kapazität des Bipolartransistors 21 in Verbindung mit der Sperrschichtkapazität der Diode 22, wird der Bipolartransistor 20 leitend geschalten. Dieser stellt somit der dritten Thyristorschaltung an der Basis des Bipolartransistors 16 einen Strom zur Verfügung, so daß dieser zündet. Dieser verstärkte Strom wird der Basis des Bipolartransistors 10 der ersten Thyristorschaltung 7 zugeführt. Die erste Thyristorschaltung 7 kann somit zünden, wobei aus dem Ladungsspeicher 35 während des Einschaltvorganges Ladung zum Verbindungspunkt 51 fließt und somit die Gates der MOSFETs 5,6 auflädt.

Das Zünden der ersten Thyristorschaltung 7 durch die dritte Thyristorschaltung findet jedoch nur statt, wenn am ersten Versorgungspotential 1 eine ausreichend hohe Betriebsspannung anliegt. Ist dies nicht der Fall, wird die dritte Thyristorschaltung nicht gezündet, wodurch der Leistungs-Halbleiterschalter vor einer zu kleinen Gate-Spannung geschützt wird.

Nach der Schaltflanke wird, abhängig von der Größe des Widerstandes 23, der Haltestrom der ersten Thyristorschaltung 7 so lange nicht unterschritten, solange die Gates des Leistungs-Halbleiterschalters 3 nicht vollständig aufgeladen sind. Dabei wird der Pfad über die Widerstände 24,25,26 bzw. die Diode 27 gespeist. Wird der Haltestrom der ersten Thyristorschaltung 7 unterschritten, so werden die Widerstände 24,25,26 bzw. die Diode 27 über den Pfad Widerstand 29 - Diode 28 - Widerstand 19 gespeist.

Die zweite Thyristorschaltung 8 wird im Normalfall an der Basis des Bipolartransistors 11 über die Diode 18 und den Bipolartransistor 21 aufgrund eines negativen Spannungsanstiegs gezündet. Die zweite Thyristorschaltung 8 löscht nach Entladung der Gate-Kapazitäten des Leistungs-Halbleiterschalters 3 selbsttätig. Wird der Spannungsabfall an den Drain- bzw. Source-Elektroden der MOSFETs 5,6 infolge eines Überstromes (z.B. durch Überlastung), infolge eines Temperaturanstieges (z.B. durch unzureichende Kühlung) oder infolge zu geringer Gate-Spannung (z.B. durch zu geringe Betriebsspannung) zu hoch, dann steigt die Spannung am Widerstand 26, wodurch die zweite Thyristorschaltung 8 an der Basis des Bipolartransistors 12 gezündet wird. Die Gate-Kapazitäten des Leistungs-Halbleiterschalters 3 werden dadurch vorzeitig entladen.

Steigt die Spannung am Emitter des Bipolartransistors 11 der zweiten Thyristoranordnung 8 aufgrund eines Spannungsanstiegs am Gate des Leistungs-Halbleiterschalters 3 aufgrund der Wirkung der Miller-Kapazität an, dann findet ebenfalls eine Zündung der zweiten Thyristorschaltung 8 statt.

In beiden Fällen wird ein Haltestrom über den Pfad Widerstand 29 - Diode 28 - Widerstand 19 geführt. Um derartige ungewollte Betriebszustände erkennen zu können, ist es vorteilhaft, die Diode 28 als Leuchtdiode oder als Optokoppler auszuführen, wodurch eine Verriegelung der Ansteuerschaltung bewirkt werden könnte.

In beiden Fällen löscht die zweite Thyristorschaltung 8 erst mit Beginn der Leitphase des Bipolartransistors 21. Dieser Zeitpunkt entspricht dem normalen Ende der Leitphase des Leistungs-Halbleiterschalters 3.

Mit den Widerständen 30,31 werden Arbeitspunkte der Ansteuerschaltung festgelegt. Der Widerstand 34 dient lediglich der Entkopplung. Mit den Widerständen 32,33 findet eine Flankenverrundung des Spannungsverlaufs am Gate des Leistungs-Halbleiterschalters 3 statt. Hierdurch können elektromagnetische Abstrahlungen verringert werden. Diese Widerstände sind nicht zwangsläufig notwendig und könnten auch entfallen. Statt des Bipolartransistors 21 könnte alternativ auch ein Optokoppler verwendet werden.

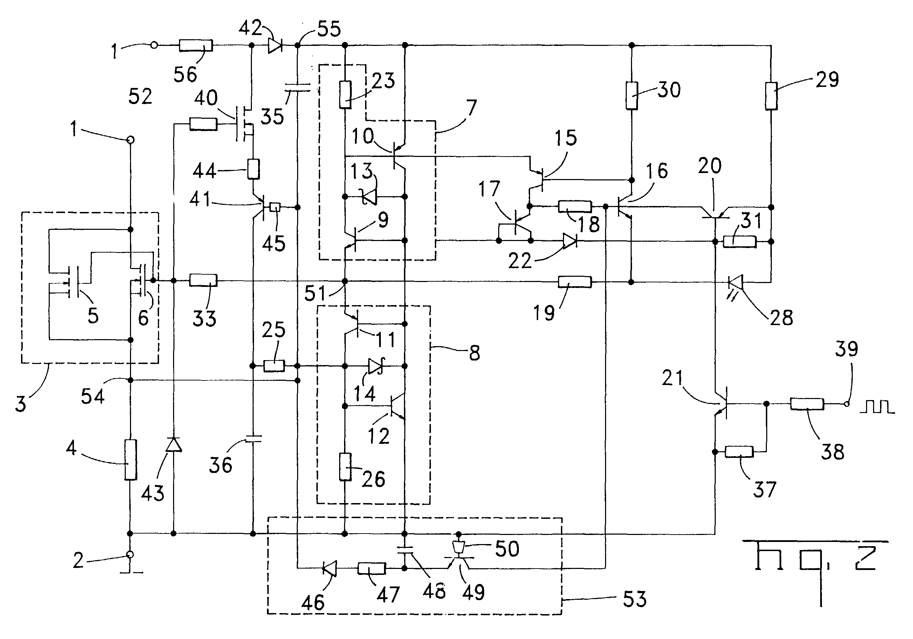

In der Figur 2 ist ein zweites Ausführungsbeispiel der erfindungsgemäßen Ansteuerschaltung dargestellt, wobei diese für eine High-Side-Konfiguration vorgesehen ist. In diesem Fall ist die Last zwischen dem zweiten Versorgungspotentialanschluß 2 und dem Source-Anschluß des Leistungs-Halbleiterschalters 3 verbunden. Der Drain-Anschluß des Leistungs-Halbleiterschalters 3 ist somit mit dem ersten Versorgungspotentialanschluß in Kontakt.

Die Ausgestaltung der Gegentaktanordnung mit der ersten und der zweiten Thyristorschaltung sowie die Beschaltung der Thyristorschaltungen ist identisch mit der zu Figur 1 beschriebenen Verschaltung. An dieser Stelle wird deshalb auf die ausführliche Beschreibung der Verschaltung mit der dritten Thyristorschaltung, der pulsartigen Stromquelle und die Steuersignaleinrichtung verzichtet. Hierzu wird auf die Beschreibung zu Figur 1 verwiesen.

Die Ansteuerschaltung für eine High-Side-Konfiguration unterscheidet sich im wesentlichen in der Überlasterkennung sowie in der Verschaltung des Ladungsspeichers 35. Der Ladungsspeicher 35 ist einerseits über eine Diode 42, die zur Entkopplung dient, und einen Widerstand 56 mit dem ersten Versorgungspotentialanschluß 1 und andererseits mit dem Source-Anschluß des Leistungs-Halbleiterschalters 3 verbunden. Bei dem Ladungsspeicher 35 handelt es sich um einen Bootstrap-Kondensator, der über den Strompfad Widerstand 29 - Bipolartransistor 20 - Bipolartransistor 21 aufgeladen wird. Die Spannung am Knotenpunkt 55 liegt somit bei aufgeladenem Kondensator 35 um einen festgelegten Betrag über der Spannung am Verbindungspunkt 54, welcher den Source-Anschluß des Leistungs-Halbleiterschalters 3 darstellt.

Die Überlasterkennung besteht aus einem MOSFET 40, der mit seinem Drain-Anschluß mit dem ersten Versorgungspotentialanschluß 1, mit seinem Gate-Anschluß über einen Widerstand 52 mit dem Gate-Anschluß des Leistungs-Halbleiterschalters 3 und mit seinem Source-Anschluß über einen Widerstand 44 mit dem Emitter eines Bipolartransistors 41 verbunden ist. Der Kollektor des Bipolartransistors 44 ist mit dem Verbindungspunkt des Widerstandes 25 und des Ladungsspeichers 36, welche auch in der Low-Side-Konfiguration vorhanden sind, verbunden. Die Basis des Bipolartransistors 41 ist über einen Widerstand 45 mit dem Verbindungspunkt 54, d.h. mit dem Source-Anschluß des Leistungs-Halbleiterschalters 3, verbunden.

Der eigentliche Überlastschutz besteht aus den Widerständen 44,45 und dem Bipolartransistor 41 in Verbindung mit den Widerständen 25,26. Mittels der Widerstände 44,45 und dem Bipolartransistor 41 kann eine zwischen den Drain- und Source-Elektroden des Leistungs-Halbleiterschalters 3 anliegende Spannung in einen Strom gewandelt werden, der über die Widerstände 25,26 zum zweiten Versorgungspotentialanschluß 2 fließt. Mit steigender Spannung zwischen den Drain- und Source-Anschlüssen des Leistungs-Halbleiterschalters 3 erhöht sich auch der Strom durch den genannten Pfad. Übersteigt die Spannung am Widerstand 26 die Schwellenspannung der Basis-Emitterspannung des Bipolartransistors 12, so zündet die zweite Thyristorschaltung 8 und entlädt das Gate des Leistungs-Halbleiterschalters 3.

Um zu verhindern, daß sich auch bei ausgeschaltetem Leistungs-Halbleiterschalter 3 die Spannung an der Basis des Bipolartransistors 12 auf einen Wert erhöhen kann, der die zweite Thyristorschaltung 8 zum Zünden bringt, ist der MOSFET 40 vorgesehen. Dieser ist mit seinem Gate-Anschluß sowie mit seinem Drainanschluß dem Leistungs-Halbleiterschalter 3 parallel geschalten, d.h. wenn der Leistungs-Halbleiterschalter 3 gesperrt ist, ist ebenfalls der MOSFET 40 gesperrt, so daß kein Strom durch den Pfad Widerstand 44 - Bipolartransistor 41 - Widerstand 26 - Widerstand 25 fließen kann. Ein ungewolltes Zünden der zweiten Thyristorschaltung 8 zu einem nicht beabsichtigten Zeitpunkt ist somit unterbunden.

Mittels der Dimensionierung des Widerstandes 44 ist beeinflußbar, wie schnell der Leistungs-Halbleiterschalter 3 in einem Überlastfall abgeschaltet werden können soll. Je kleiner der Widerstand 44 dimensioniert wird, desto schneller kann eine Abschaltung erfolgen. Bei Überschreiten der Basis-Emitter-Spannung des Bipolartransistors 41, die auf einen vorgegebenen Wert dimensioniert ist, kann ein Strom über die Widerstände 25,26 zum zweiten Versorgungspotentialanschluß 2 abgeleitet werden. Zu diesem Zeitpunkt erfolgt die Zündung der zweiten Thyristorschaltung 8 und entlädt das Gate des Leistungs-Halbleiterschalters 3.

Der Bootstrap-Kondensator 35 sorgt dafür, daß auch bei schwankender Versorgungsspannung an den Versorgungspotentialanschlüssen 1,2 die Spannung am Gate-Anschluß des Leistungs-Halbleiterschalters 3 für eine begrenzte Zeit (ca. 5-10 sec., abhängig von der Dimensionierung des Bootstrap-Kondensators 35) erhalten bleibt. Insbesondere im Einschaltmoment kann bei großen Strömen die Versorgungsspannung schwanken. Durch den Bootstrap-Kondensator 35 ist sichergestellt, daß ein unbeabsichtigtes Ausschalten des Leistungs-Halbleiterschalters 1 unterbleibt. Die Diode 42 sorgt dafür, daß sich der Ladungsspeicher 35 nicht in Richtung des ersten Versorgungspotentialanschlusses 1 entladen kann.

Die Ladung des Bootstrap-Kondensators 35 fließt beim Einschalten der ersten Thyristorschaltung 7 über die erste Thyristorschaltung 7 zu dem Gate des Leistungs-Halbleiterschalters 3. Die in dem Ladungsspeicher 35 zur Verfügung stehende Ladung sorgt damit für ein rasches Einschalten des Leistüngs-Halbleiterschalters 3.

Ein Widerstand 56 zwischen dem Anodenanschluß der Diode 42 und dem ersten Versorgungspotentialanschluß 1 begrenzt bei einer Überlast und beim Einschalten den Stromfluß.

Mittels der eben beschriebenen Ansteuerschaltung kann eine resistive, eine kapazitive oder eine resistiv-kapazitive Last 4 betrieben werden. Handelt es sich bei der Last 4 jedoch um einen induktiven oder teilweise induktiven Verbraucher, so werden vorteilhaft einige weitere Schaltungselemente vorgesehen. So ist insbesondere das Vorsehen einer Diode 43 vorteilhaft, die katodenseitig mit dem Gate-Anschluß des Leistungs-Halbleiterschalters 3 und anodenseitig mit dem zweiten Versorgungspotentialanschluß 2 verbunden ist.

Weiterhin ist ein Einschaltschutz 53 vorgesehen, der verhindert, daß während des Abmagnetisierens des induktiven Verbrauchers 4 eine Zündung der ersten Thyristorschaltung 7 erfolgt. Der Einschaltschutz 53 ist zwischen dem Verbindungspunkt 54, d.h. dem Verbindungspunkt zwischen der Last 4 und dem Leistungs-Halbleiterschalter 3, und der pulsartigen Stromquelle 20, d.h. dem Bipolartransistor 20 vorgesehen. Mit dem Verbindungspunkt 54 ist der Katodenanschluß einer Diode 46 verbunden. Anodenseitig ist diese über einen Widerstand 47 mit dem Emitter eines Bipolartransistors 49 verschalten. Die Basis des Bipolartransistors 49 ist über einen Widerstand 50 mit dem zweiten Versorgungspotentialanschluß 2 verbunden. Der Kollektor des Bipolartransistors 49 steht mit dem Kollektor des Bipolartransistors 20 in Verbindung. Alternativ könnte der Kollektor des Bipolartransistors 49 auch mit dem Emitter des Bipolartransistors 20 in Verbindung stehen. Weiterhin ist ein Ladungsspeicher 48 zwischen dem Emitter des Bipolartransistors 49 und dem zweiten Versorgungspotentialanschluß 2 vorgesehen.

Beim Abmagnetisieren der induktiven Last 4 kann das Potential am Verbindungspunkt 24 unter das Potential des zweiten Versorgungspotentialanschlusses 2 fallen. Während dieses Zeitraumes darf keine Zündung der ersten Thyristorschaltung 7 erfolgen. Aus diesem Grund wird der über den Widerstand 29 fließende Strom über den Einschaltschutz 53 abgeleitet. Es wird damit verhindert, daß der Bipolartransistor 16 der dritten Thyristorschaltung zündet und somit eine Zündung der ersten Thyristorschaltung 7 veranlaßt. Der Einschaltschutz 53 verhindert auch, daß bei einer abfallenden Flanke am Steuersignal 39 die Zündung der dritten und damit der ersten Thyristorschaltung ausgelöst wird.

Mit der erfindungsgemäßen Ansteuerschaltung wird eine Gegentaktanordnung zur Ansteuerung eines Leistungs-Halbleiterschalters für sehr große Ströme vorgeschlagen, die eine schnelle Gate-Spannungsänderung ermöglicht. Weiterhin wird ein Unterschreiten üblicher Gate-Schwellenspannungen, eine sichere taktweise Sperrung des Leistungs-Halbleiterschalters im Überlastfall als auch bei einer Unterspannung ermöglicht.

## Patentansprüche

1. Ansteuerschaltung für zumindest einen Leistungs-Halbleiterschalter (3), der seriell mit einer Last (4) zwischen einem ersten und einem zweiten Versorgungspotentialanschluß (1,2) verschalten ist, mit einer Gegentaktendstufe, die zwei in Reihe verschaltete Halbleiterschalter (7;8) aufweist, die von einer Steuerschaltung gesteuert werden,
**dadurch gekennzeichnet, daß**
die Halbleiterschalter (7;8) der Gegentaktendstufe als eine erste und eine zweite Thyristorschaltung ausgeführt sind.

2. Ansteuerschaltung nach Anspruch 1,
**dadurch gekennzeichnet, daß**
die erste und die zweite Thyristorschaltung jeweils zwei komplementäre Halbleiterschalter (9, 10;11, 12), insbesondere Bipolartransistoren, aufweist, deren Basis- und Kollektoranschlüsse miteinander verschalten sind.

3. Ansteuerschaltung nach Anspruch 2,
**dadurch gekennzeichnet, daß**
eine Diode (13; 14) zwischen den Basis- und KollektorAnschlüssen der Halbleiterschalter (9,10;11,12) zumindest einer der Thyristorschaltungen (7; 8) verschalten ist.

4. Ansteuerschaltung nach Anspruch 3,
**dadurch gekennzeichnet, daß**
die Diode (13; 14) eine Schottky-Diode ist.

5. Ansteuerschaltung nach einem der Ansprüche 2 bis 4,
**dadurch gekennzeichnet, daß**
ein erster Halbleiterschalter (9) der ersten Thyristorschaltung (7) und ein erster Halbleiterschalter (11) der zweiten Thyristorschaltung (8) jeweils mit ihren Basis-und Emitter-Anschlüssen verbunden sind und daß der Verbindungspunkt der Emitter-Anschlüsse (51) mit dem Steueranschluß des zumindest einen Leistungs-Halbleiterschalters (3) gekoppelt ist und daß die zwei besagten Halbleiterschalter (9; 11) der Thyristorschaltungen (7; 8) vom komplementären Typ sind.

6. Ansteuerschaltung nach einem der Ansprüche 1 bis 5,
**dadurch gekennzeichnet, daß**
eine dritte Thyristorschaltung (15,16) mit den Basisanschlüssen der Halbleiterschalter der ersten Thyristorschaltung (7) verbunden ist.

7. Ansteuerschaltung nach Anspruch 6,
**dadurch gekennzeichnet, daß**
die dritte Thyristorschaltung (15,16) durch eine pulsartige Stromquelle gezündet wird, die mit einer Steuersignaleinrichtung (21,37,38,39) verbunden ist.

8. Ansteuerschaltung nach einem der Ansprüche 1 bis 7,
**dadurch gekennzeichnet, daß**
die erste Thyristorschaltung (7) mit einem Ladungsspeicher (35) verbunden ist.

9. Ansteuerschaltung nach einem der Ansprüche 8 oder 9,
**dadurch gekennzeichnet, daß**
die zweite Thyristorschaltung (8) über eine Diode (22) mit der Steuersignaleinrichtung (21,37,38,39) verbunden ist.

10. Ansteuerschaltung nach einem der Ansprüche 2 bis 9,
**dadurch gekennzeichnet, daß**
die Basis- und Emitter-Anschlüsse der zweiten Halbleiterschalter (10;12) der ersten und der zweiten Thyristorschaltung (7;8) jeweils über einen Widerstand (23;26) mit dem ersten bzw. zweiten Versorgungspotentialanschluß (1,2) verbunden sind.

11. Ansteuerschaltung nach einem der Ansprüche 2 bis 10, **dadurch gekennzeichnet, daß**
eine Serienschaltung aus einem Widerstand (19) und einer Diode (28) zwischen dem ersten
Versorgungspotentialanschluß (1) und dem Verbindungspunkt (51) zwischen der ersten und der zweiten Thyristorschaltung (7;8) vorgesehen ist.

12. Ansteuerschaltung nach einem der Ansprüche 1 bis 11, **dadurch gekennzeichnet, daß**
die Last in Low-Side-Konfiguration verschalten ist.

13. Ansteuerschaltung nach einem der Ansprüche 1 bis 11, **dadurch gekennzeichnet, daß**
die Last in High-Side-Konfiguration verschalten ist.

14. Ansteuerschaltung nach Anspruch 11 und 12,
**dadurch gekennzeichnet, daß**
eine Überlast- bzw. Unterspannungserkennung eine Serienschaltung zweier Widerstände (24,25) beinhaltet, die zwischen dem Verbindungspunkt (51) zwischen der ersten und der zweiten Thyristorschaltung (7;8) und dem Basisanschluß des zweiten Halbleiterschalters (12) der zweiten Thyristorschaltung (8) gelegen ist.

15. Ansteuerschaltung nach Anspruch 14,
**dadurch gekennzeichnet, daß**
an den Verbindungspunkt der beiden Widerstände (24,25) ein Ladungsspeicher (36) geschalten ist.

16. Ansteuerschaltung nach Anspruch 11 und 13,
**dadurch gekennzeichnet, daß**
eine Überlasterkennung Mittel zur Wandlung der Drain-Source-Spannung des zumindest einen Leistungs-Halbleiterschalters (3) in einen Strom enthält, der dem Basisanschluß des zweiten Halbleiterschalters (12) der zweiten Thyristorschaltung (8) zugeführt wird.

17. Ansteuerschaltung nach Anspruch 16,
**dadurch gekennzeichnet, daß**
die Mittel zumindest einen Widerstand (44) und einen mit der Laststrecke dazu seriell verschalteten Halbleiterschalter (41) aufweisen.

18. Ansteuerschaltung nach Anspruch 17,
**dadurch gekennzeichnet, daß**
die Mittel zusätzlich einen Ladungsspeicher (36) beinhalten.

19. Ansteuerschaltung nach einem der Ansprüche 16 bis 18, **dadurch gekennzeichnet, daß**
die Überlasterkennung über einen mit dem Leistungs-Halbleiterschalter (3) gekoppelten MOSFET (40) aktiviert wird.

20. Ansteuerschaltung nach einem der Ansprüche 16 bis 19, **dadurch gekennzeichnet, daß**
bei einer induktiven Last(4) ein mit der pulsförmigen Stromquelle (20) verbundener Einschaltschutz (53) vorgesehen ist.

21. Ansteuerschaltung nach einem der Ansprüche 16 bis 20, **dadurch gekennzeichnet, daß**
ein Ladungsspeicher (35) über die erste
Thyristorschaltung (7) zwischen der Steuerelektrode und dem Verbindungspunkt (54) zwischen den Leistungs-Halbleiterschalter (3) und der Last (4) geschalten ist.
